# EUROPEAN PATENT APPLICATION

(11) **EP 2 426 816 A1**
(43) Date of publication of application: **07.03.2012**
(21) Application number: 10769416.8
(22) Date of filing: 01.02.2010
(51) Int. Cl.: H03F 1/07, H03F 3/24, H03F 3/68, H04B 1/04

(54) **POWER AMPLIFIER**

(30) Priority: 28.04.2009 JP 2009109485
(71) Applicant: Panasonic Corporation, Kadoma-shi Osaka 571-8501 (JP)
(72) Inventor: UCHIYAMA, Kazuhiro, Osaka 540-6207 (JP)
(74) Representative: Grünecker, Kinkeldey, Stockmair & Schwanhäusser
(86) International application number: PCT/JP2010/000585
(87) International publication number: WO 2010/125714

(57) **Abstract**

An efficient power amplifier with a design which, even in cases when the phase characteristics of high frequency devices used in a main amp and peaking amp differ, reduces the combination loss of the two amps at a wide range of output levels. A class AB power amplifier (103) using an LDMOS device amplifies divided input signals, and a class AB power amplifier (104) using a GaN device amplifies the signals output from the power amplifier (103). Further, a class C power amplifier (107) using a GaN device amplifies ?/4 delayed input signals, and a class C power amplifier (108) using an LDMOS device amplifies the signals output from the power amplifier (107). A combining circuit (109) combines the signals which were amplified by the power amplifier (108) with the signals which were amplified by the power amplifier (104) and subjected to impedance conversion by an impedance converter circuit (105).

## Description

### Technical Field

The present invention relates to a power amplifier.

### Background Art

In recent years, a Doherty amplifier has been examined as an amplifier with high efficiency. FIG.1 illustrates a block diagram of a general Doherty amplifier (see Non-Patent Literature 1). In FIG.1, a signal inputted from input terminal 11 is distributed by input distributor 12. One of the distributed signals is amplified in main amplifier 13 that is A-class or AB-class-biased, and then impedance-converted in impedance conversion circuit 14.

The other of the distributed signals is inputted to peak amplifier 16 through λ/4 line path 15, and amplified by peak amplifier 16 that is B-class or C-class-biased.

Signals that are outputted from impedance conversion circuit 14 and peak amplifier 16 are synthesized and outputted from output terminal 17.

In an attempt to achieve higher efficiency in this general Doherty amplifier, it is necessary to use high-frequency devices of high performance. For example, a GaN device has been known as a high-frequency device of high performance; however, in comparison with an LDMOS device that is used worldwide, the GaN device generally requires higher costs. For this reason, reduction of costs is required, while effectively utilizing the advantages of the devices of high performance.

For this reason, an examination has been made on a structure in which a GaN device is used only for the main amplifier that predominantly relates to the efficiency on the operation point of a Doherty amplifier, with a low-cost device being used as the peak amplifier; however, the synthesizing process of different kinds of devices fail to make the phase characteristics in conformity with each other, making it impossible to easily achieve the structure. In this case, different devices mean inconformity in phase characteristics. As a result, a phase difference between two amplifiers to be operated in parallel with each other varies constantly with respect to the output level, with the result that a loss is caused upon synthesizing the outputs. When the phase difference between the two amplifiers becomes 180 degrees, the output signals of the two are cancelled and damage the two devices in the worst scenario.

In an attempt to solve this problem of inconformity in phase characteristics of two amplifiers, for example, Patent Literature 1 and Patent Literature 2 have disclosed power amplifiers. Patent Literature 1 has disclosed a structure in which, in a bias controlling process of a Doherty power amplifier having a zero-bias current, a power-supply gain is stably maintained by using a function of the power level in the Doherty power amplifier. With this structure, since the bias to the carrier amplifier is reduced as the bias to the peak amplifier is increased, it is possible to reduce a mutual modulation distortion in the Doherty power amplifier by the reduction in gain variation. In other words, by improving the linearity of the two amplifiers, it is possible to cancel synthesis loss due to deviations of the phase characteristics of these amplifiers.

Moreover, Patent Literature 2 has disclosed a structure in which a phase-shift device for adjusting an electrical length in a synthesizing section for synthesizing the output of the peak amplifier and the output of the carrier amplifier. With this arrangement, it is possible to cancel the synthesis loss due to deviations in the phase characteristics of the two amplifiers.

### Citation List

### Patent Literature

PTL 1
   Published Japanese Translation No. 2000-513535 of the PCT International Publication
PTL 2
   Japanese Patent Application Laid-Open No. 2006-332829

### Non-Patent Literature

NPL 1
   "A New High Efficiency Power Amplifier for Modulated Waves", Proceedings of the Institute of Radio Engineers, Vol.24, No.9, pp.1163-1182, September 1936

### Summary of Invention

### Technical Problem

However, in the technique disclosed in Patent Literature 1, although it is possible to alleviate an abrupt rotation of the phase generated in a region at which the operation of the peak amplifier is started and consequently to improve the linearity of the output signal of the Doherty amplifier, since it is not possible to improve the phase rotation near the saturation, a problem is raised in that synthesis loss occurs near the saturated output.

Moreover, in the technique disclosed in Patent Literature 2, the output impedance is adjusted based upon the electric wave length of the output impedance; therefore, although the phase differences in a certain specific output level are made in conformity with each other to reduce the output synthesis loss, a problem is raised in that it is not possible to deal with variation in phase characteristics caused by the output level.

the present invention to provide a power amplifier with high efficiency, which, even when phase characteristics of high-frequency devices for use in a main amplifier and a peak amplifier are different, can reduce synthesis loss of the two amplifiers in a wide range of output levels.

### Solution to Problem

A power amplifier of the present invention employs a configuration having: a distribution section that distributes an input signal; a first amplifying section in which two high-frequency devices having opposite inclinations of phase characteristics in a saturated region are connected in series, and which amplifies one of the distributed input signals; a phase shift section that delays the phase of the other distributed input signal by λ/4; a second amplifying section in which two high-frequency devices having the same structure as the two high-frequency devices used in the first amplifying section are connected in series in a reversed order from the first amplifying section, and which amplifies the input signal with a phase delayed by λ/4, using a lower operation point than in the first amplifying section; a conversion section that converts an impedance of the signal amplified by the first amplifying section; and a synthesizing section that synthesizes the signal with the converted impedance and the signal amplified by the second amplifying section.

### Advantageous Effects of Invention

The present invention makes it possible to provide a power amplifier with high efficiency, which, even when phase characteristics of high-frequency devices for use in a main amplifier and a peak amplifier are different, can reduce synthesis loss of the two amplifiers in a wide range of output levels.

### Brief Description of Drawings

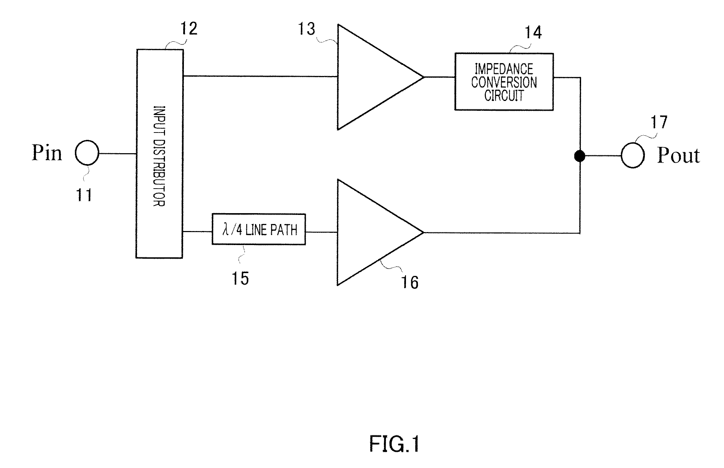

FIG.1 is a block diagram showing a general Doherty amplifier;
FIG.2 shows a structure of a Doherty amplifier in accordance with embodiment 1 of the present invention;
FIG.3 illustrates a characteristic curve that shows phase variation relative to an output level of a power amplifier on a preceding stage of a main amplifier;
FIG.4 illustrates a characteristic curve that shows phase variation relative to an output level of a power amplifier in a subsequent stage of the main amplifier;
FIG.5 illustrates a characteristic curve that shows phase variation relative to an output level of the main amplifier;
FIG.6 illustrates a characteristic curve that shows phase variation relative to an output level of a power amplifier on a preceding stage of a peak amplifier;
FIG.7 illustrates a characteristic curve that shows phase variation relative to an output level of a power amplifier in a subsequent stage of the peak amplifier;
FIG.8 illustrates a characteristic curve that shows phase variation relative to an output level of the peak amplifier;
FIG.9 shows a structure of a Doherty amplifier in accordance with embodiment 2 of the present invention; and
FIG.10 shows a structure of a Doherty amplifier in accordance with embodiment 3 of the present invention.

### Description of Embodiments

Referring to the drawings, the following description will discuss embodiments of the present invention in detail.

### (Embodiment 1)

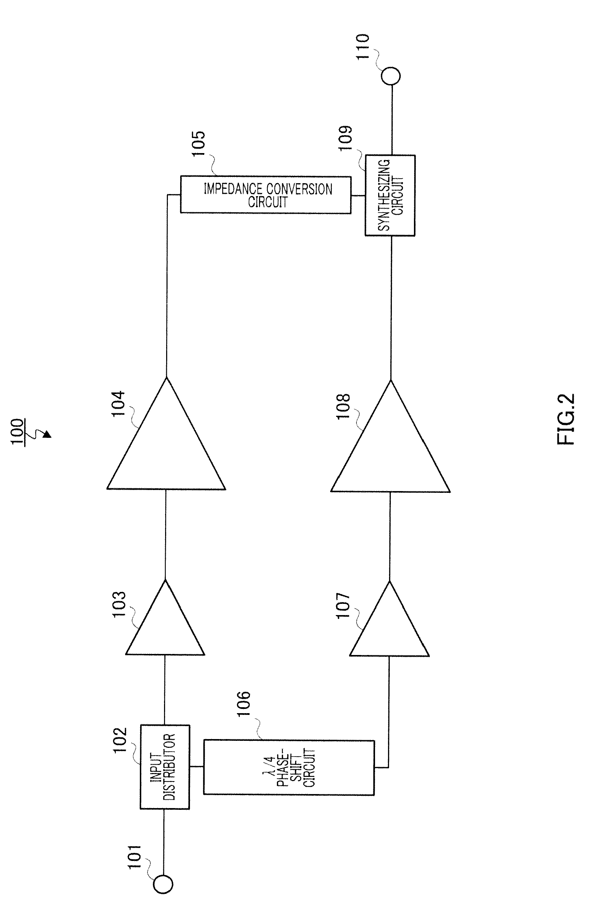

FIG.2 shows a structure of Doherty amplifier 100 in accordance with embodiment 1 of the present invention. In Fig.2, input distributor 102 distributes a signal inputted from input terminal 101, and outputs one portion of the distributed signal to power amplifier 103, while outputting the other portion of the distributed signal to λ/4 phase-shift circuit 106.

Power amplifier 103, which is an AB-class power amplifier using an LDMOS device, amplifies signals distributed by input distributor 102, and outputs the resulting signals to power amplifier 104.

Power amplifier 104, which is an AB-class power amplifier using a GaN device, amplifies the signal outputted from power amplifier 103, and outputs the resulting signal to impedance conversion circuit 105. In this case, power amplifier 103 and power amplifier 104 are connected in series with each other to form a main amplifier serving as a first amplifying section. Moreover, power amplifier 103 is also referred to as a power amplifier on a preceding stage or a preamplifier in the main amplifier, and power amplifier 104 is referred to also as a power amplifier in a subsequent stage in the main amplifier.

Impedance conversion circuit 105 converts an impedance of a signal outputted from power amplifier 104, and outputs the resulting signal to synthesizing circuit 109.

Moreover, λ/4 phase-shift circuit 106 delays the phase of the signal distributed by input distributor 102 by 90 degrees (λ/4), and outputs the resulting signal to power amplifier 107.

Power amplifier 107, which is a C-class power amplifier using a GaN device, amplifies the signal outputted from λ/4 phase-shift circuit 106, and outputs the resulting signal to power amplifier 108.

Power amplifier 108, which is a C-class power amplifier using an LDMOS device, amplifies the signal outputted from power amplifier 107, and outputs the resulting signal to synthesizing circuit 109. Additionally, power amplifiers 107 and 108 are connected in series with each other to form a peak amplifier serving as a second amplifying section. Moreover, power amplifier 107 is also referred to as a power amplifier on a preceding stage or a preamplifier in the peak amplifier, and power amplifier 108 is referred to also as a power amplifier in a subsequent stage.

Synthesizing circuit 109 synthesizes a signal outputted from impedance conversion circuit 105 and a signal outputted from power amplifier 108, and output the resulting signal through output terminal 110.

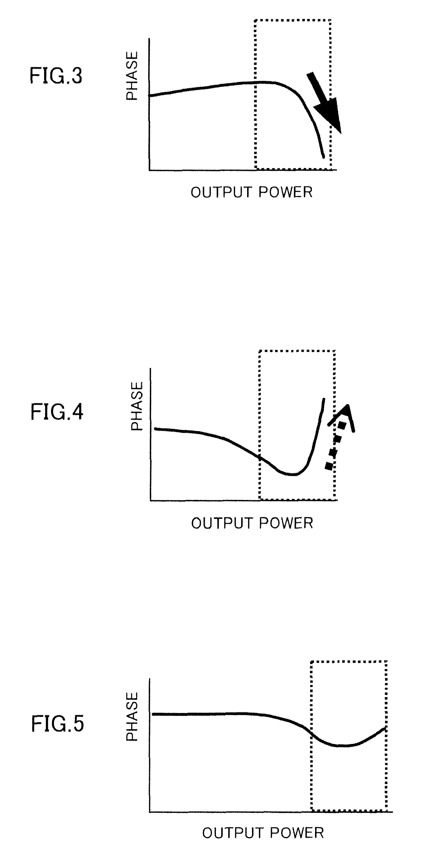

The following description will discuss a phase characteristic of the power amplifier. FIG.3 illustrates a characteristic curve showing phase variation relative to the output level of power amplifier 103, and FIG.4 illustrates a characteristic curve showing phase variation relative to the output level of power amplifier 104. Moreover, FIG.5 illustrates a characteristic curve showing phase variation relative to the output level of the main amplifier constituted by power amplifiers 103 and 104.

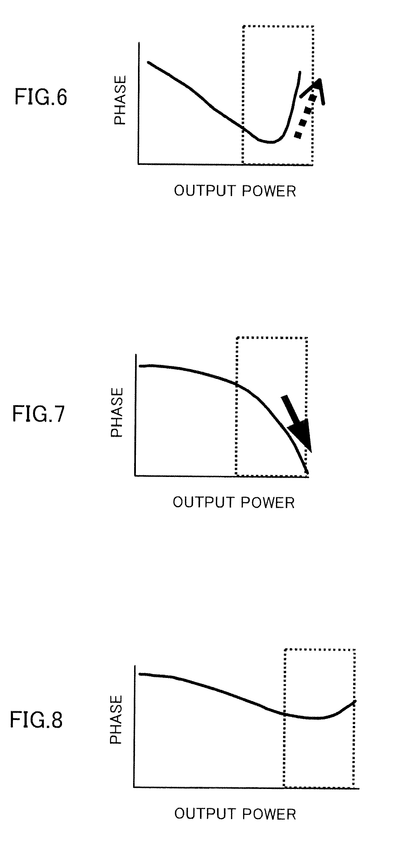

FIG.6 illustrates a characteristic curve showing phase variation relative to the output level of power amplifier 107, and FIG.7 illustrates a characteristic curve showing phase variation relative to the output level of power amplifier 108. Moreover, FIG.8 illustrates a characteristic curve showing phase variation relative to the output level of the peak amplifier constituted by power amplifiers 107 and 108.

In FIGs.3 to 8, each of regions surrounded by a dotted line represents a saturated region. The Doherty amplifier is designed under the premise that it is operated by a modulation signal, and not the maximum efficiency obtained at the highest output, but the operation efficiency under a certain OBO (Output power Back Off) is more important such that regions having an important total characteristic are indicated as the saturated region.

The following description will discuss an operation principle of Doherty amplifier 100 shown in FIG.2. A phase characteristic relative to an output level in a saturated region of a high-frequency device is a characteristic inherent to the device, and cannot be adjusted by a bias voltage of the device and an input/output matching circuit thereof. In the case of the same devices, the inherent phase characteristic of course exerts the same tendency even when the devices have different power ranks. For example, in the case of the GaN device, any device having any power rank tends to have a positive inclination in phase variation in the saturated region (see FIGs.4 and 6); however, in the case of the LDMOS device, any device having any power rank tends to have a negative inclination therein (see FIGs.3 and 7).

Moreover, the phase characteristic of the output of a plurality of devices connected in series with one after another corresponds to a characteristic obtained by adding the phase characteristics of the respective devices to one after another. Therefore, as shown in FIG.2, for example, in the case when a GaN device is used at the last stage, an LDMOS device is connected to the preamplifier, while, in the case when an LDMOS device is used at the last stage, a GaN device is connected to the preamplifier, such that the phase characteristic of the main amplifier constituted by power amplifiers 103 and 104 in the vicinity of the saturated region and the phase characteristic of the peak amplifier constituted by power amplifiers 107 and 108 can be made in conformity with each other (see FIGs.5 and 8).

In this manner, in Doherty amplifier 100, two AB-class high-frequency devices whose inclinations in the phase characteristic in the saturated region are reversed to each other, that is, a GaN device and an LDMOS device, are connected in series with each other to form a main amplifier, while C-class GaN device and LDMOS device having the same structures as the two high-frequency devices used as the main amplifier are series-connected to each other in an order different from that of the main amplifier so as to form a peak amplifier.

In this manner, in accordance with embodiment 1, expensive high-performance devices, such as GaN devices, are used for the main amplifier, while inexpensive high-frequency devices are used for the peak amplifier, and in each of the amplifiers, devices having the same phase characteristics as the phase characteristics of the devices used in the other amplifier are connected in series with each other so that the phase characteristics of the main amplifier and the peak amplifier are made in conformity with each other so that synthesis loss of the two amplifiers is reduced in a wide range of the output level is reduced; thus, it is possible to achieve a Doherty amplifier having high efficiency.

Additionally, in FIG.2, a configuration by the use of GaN devices and LDMOS devices is shown as a reference example, any configuration of any Doherty amplifiers corresponding to combinations of devices having different phase characteristics may be used with the same effects.

### (Embodiment 2)

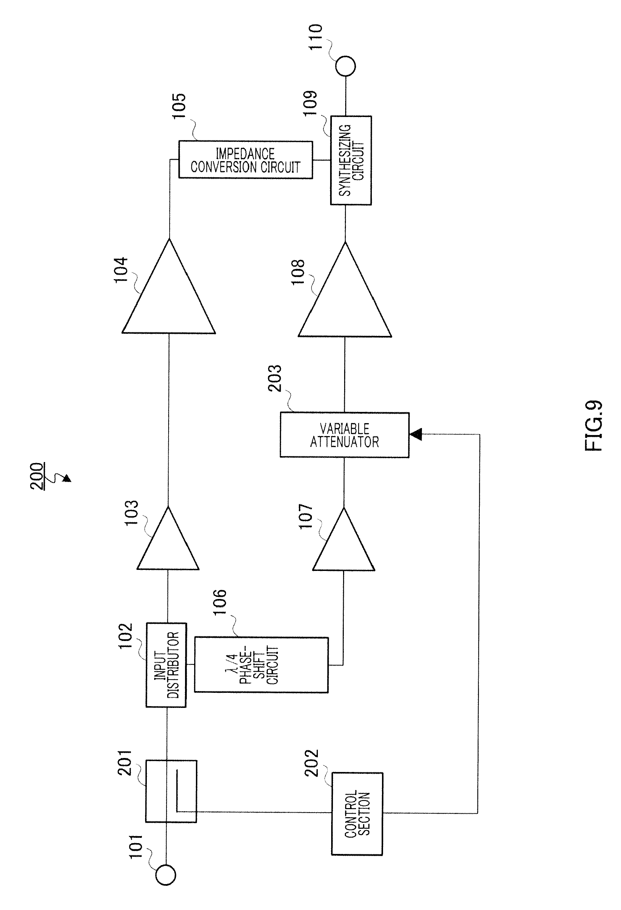

FIG.9 shows a configuration of Doherty amplifier 200 in accordance with embodiment 2 of the present invention. FIG.9 is different from FIG.2 only in that input level detection section 201, control section 202 and variable attenuator 203 are added thereto.

Input level detection section 201 detects a level of a signal inputted from input terminal 101, and outputs the detected level (input level) to control section 202. In this case, input level detection section 201 is prepared, for example, as a configuration that can detect the size of the input level, such as a directive coupler, a thermal sensor, a wave-detector circuit, and the like.

Based upon the input level outputted from input level detection section 201, control section 202 controls variable attenuator 203, which will be described later.

Variable attenuator 203 is installed between power amplifier 107 and power amplifier 180 in the peak amplifier, and in accordance with the control of control section 202, attenuates the power of a signal outputted from power amplifier 107, and outputs the signal whose power has been attenuated to power amplifier 108.

Since this arrangement makes the region to be used for adding the phase characteristic of power amplifier 107 and the phase characteristic of power amplifier 108 to each other variably changed, the inclination of the characteristic curve to be added can be controlled so that the phase characteristics of the main amplifier and the peak amplifier can be made in conformity with each other with higher precision. Thus, it becomes possible to achieve a Doherty amplifier with higher efficiency.

In this manner, in accordance with embodiment 2, by attenuating the output power of the power amplifier on the preceding stage in the peak amplifier based upon the input level of an input signal, the region to be used for adding the phase characteristic of the power amplifier on the preceding stage and the phase characteristic of the power amplifier on the succeeding stage to each other can be variably changed so that the inclination of the characteristic curve to be added can be controlled, and the phase characteristics of the main amplifier and the peak amplifier can be consequently made in conformity with each other with higher precision. As a result, the synthesis loss of the two amplifiers can be reduced so that it is possible to realize a Doherty amplifier with higher efficiency.

### (Embodiment 3)

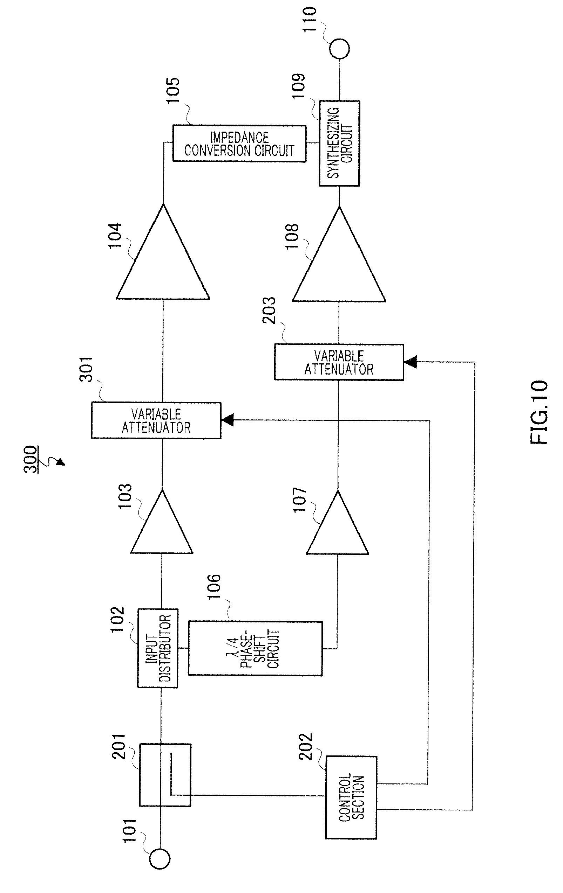

FIG.10 shows a configuration of Doherty amplifier 300 in accordance with embodiment 3 of the present invention. FIG.10 is different from FIG.9 only in that variable attenuator 301 is thereto.

Variable attenuator 301 is installed between power amplifier 103 and power amplifier 104 in the main amplifier, and in accordance with the control by control section 202, attenuates the power of a signal outputted from power amplifier 103, and outputs the signal whose power has been attenuated to power amplifier 104.

Since this arrangement makes the region to be used for adding the phase characteristic of power amplifier 103 and the phase characteristic of power amplifier 104 to each other variably changed, the inclination of the characteristic curve to be added can be controlled so that the phase characteristics of the main amplifier and the peak amplifier can be made in conformity with each other with higher precision. Thus, it becomes possible to achieve a Doherty amplifier with by far higher efficiency.

In this manner, in accordance with embodiment 3, by attenuating the output powers of the power amplifiers in the main amplifier and the peak amplifier based upon the input level of an input signal, the region to be used for adding the phase characteristic of the power amplifier on the preceding stage and the phase characteristic of the power amplifier on the succeeding stage to each other can be variably changed so that the inclination of the characteristic curve to be added can be controlled, and the phase characteristics of the main amplifier and the peak amplifier can be consequently made in conformity with each other with higher precision. As a result, the synthesis loss of the two amplifiers can be reduced so that it is possible to realize a Doherty amplifier with by far higher efficiency.

The disclosure of Japanese Patent Application No. 2009-109485, filed on April 28, 2009, including the specification, drawings and abstract, is incorporated by reference in its entirety.

### Industrial Applicability

The power amplifier of the present invention can be applied, for example, to a wireless communication device, a digital television transmitter, etc.

## Claims

1. A power amplifier comprising:
a distribution section that distributes an input signal;
a first amplifying section in which two high-frequency devices having opposite inclinations of phase characteristics in a saturated region are connected in series, and which amplifies one of the distributed input signals;
a phase shift section that delays the phase of the other distributed input signal by λ/4;
a second amplifying section in which two high-frequency devices having the same structure as the two high-frequency devices used in the first amplifying section are connected in series in a reversed order from the first amplifying section, and which amplifies the input signal with a phase delayed by λ/4, using a lower operation point than in the first amplifying section;
a conversion section that converts an impedance of the signal amplified by the first amplifying section; and
a synthesizing section that synthesizes the signal with the converted impedance and the signal amplified by the second amplifying section.

2. The power amplifier according to claim 1, further comprising:
an input level detection section that detects an input level of the input signal; and
a first variable attenuating section that is connected between two high-frequency devices in the second amplifying section, and attenuates power of a signal outputted from the high-frequency devices, based upon the detected input level.

3. The power amplifier according to claim 2, further comprising a second variable attenuating section that is connected between two high-frequency devices in the first amplifying section, and attenuates power of a signal outputted from the high-frequency devices, based upon the detected input level.

4. The power amplifier according to claim 1, wherein the high-frequency devices are GaN devices.

## Amended claims

### Amended claims under Art. 19.1 PCT

**1.** Amended)
A power amplifier comprising:
a distribution section that distributes an input signal;
a first amplifying section in which two high-frequency devices having opposite inclinations of phase characteristics in a saturated region are connected in series, and which amplifies one of the distributed input signals;
a phase shift section that delays the phase of the other distributed input signal by 1/4;
a second amplifying section in which two high-frequency devices having the same structure as the two high-frequency devices used in the first amplifying section are connected in series in a reversed order from the first amplifying section, and which amplifies the input signal with a phase delayed by λ/4, using a lower operation point than in the first amplifying section;
a conversion section that converts an impedance of the signal amplified by the first amplifying section; and
a synthesizing section that synthesizes the signal with the converted impedance and the signal amplified by the second amplifying section.

**2.** Amended)
The power amplifier according to claim 1, further comprising:
an input level detection section that detects an input level of the input signal; and
a first variable attenuating section that is connected between two high-frequency amplifiers in the second amplifying section, and attenuates power of a signal outputted from the high-frequency amplifiers, based upon the detected input level.

**3.** Amended)
The power amplifier according to claim 2, further comprising a second variable attenuating section that is connected between two high-frequency amplifiers in the first amplifying section, and attenuates power of a signal outputted from the high-frequency amplifiers, based upon the detected input level.

**4.** Amended)
The power amplifier according to claim 1, wherein a GaN device is used as one of the two high-frequency amplifiers.
